(19) Europäisches Patentamt
European Patent Office
Office européen des brevets

(11) **EP 2 647 970 B1**

(12) **EUROPÄISCHE PATENTSCHRIFT**

(45) Veröffentlichungstag und Bekanntmachung des Hinweises auf die Patenterteilung:
**09.06.2021 Patentblatt 2021/23**

(51) Int Cl.:
***G01F 1/74*** *(2006.01)*

(21) Anmeldenummer: **13162016.3**

(22) Anmeldetag: **02.04.2013**

(54) **Nadelsonden-Anordnung zur Untersuchung von Mehrphasenströmungen**

Needle probe for analysis of multiphase flows

Sonde à aiguille pour l'étude des écoulements multiphasiques.

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **02.04.2012 DE 102012102870**

(43) Veröffentlichungstag der Anmeldung:
**09.10.2013 Patentblatt 2013/41**

(73) Patentinhaber: **Helmholtz-Zentrum Dresden - Rossendorf e.V.**
**01328 Dresden (DE)**

(72) Erfinder:
• **Schleicher, Eckhard**
**01219 Dresden (DE)**
• **Kayser, Stefan**
**01219 Dresden (DE)**

(56) Entgegenhaltungen:
DE-B3-102005 046 662    DE-C1- 3 201 799
GB-A- 2 292 216    US-A- 4 516 432

• MENA P C ET AL: "Measurement of gas phase characteristics using a monofibre optical probe in a three-phase flow", CHEMICAL ENGINEERING SCIENCE, OXFORD, GB, Bd. 63, Nr. 16, 1. August 2008 (2008-08-01), Seiten 4100-4115, XP023314828, ISSN: 0009-2509, DOI: 10.1016/J.CES.2008.05.010 [gefunden am 2008-05-24]
• DA SILVA M J ET AL: "A Novel Needle Probe Based on High-Speed Complex Permittivity Measurements for Investigation of Dynamic Fluid Flows", IEEE TRANSACTIONS ON INSTRUMENTATION AND MEASUREMENT, IEEE SERVICE CENTER, PISCATAWAY, NJ, US, Bd. 56, Nr. 4, 1. August 2007 (2007-08-01) , Seiten 1249-1256, XP011187925, ISSN: 0018-9456, DOI: 10.1109/TIM.2007.900419
• MARCO JOSE DA SILVA ET AL: "High-speed Complex Admittance/permittivity Needle Probe for Investigation of Multiphase Flows", IEEE INSTRUMENTATION AND MEASUREMENT TECHNOLOGY CONFERENCE (IEEE CAT. NO. 06CH37714C)IMTC, IEEE, 1. April 2006 (2006-04-01), Seiten 1937-1941, XP031057027, DOI: 10.1109/IMTC.2006.235981 ISBN: 978-0-7803-9359-2

**Beschreibung**

**Technisches Gebiet**

Die Erfindung betrifft eine Anordnung zur Untersuchung von mehrphasigen Stoffströmungen.

Die Bestimmung der Struktur und der einzelnen Phasenanteile von Mehrphasenströmungen sind vor allem beim Betrieb verfahrenstechnischer, petrochemischer oder thermohydraulischer Anlagen wichtig, bei denen die Phasenverteilung in einer Mehrphasenströmung ein wichtiger zu messender Parameter bei der Beobachtung oder der Kontrolle des Prozessablaufes oder zur Sicherheitsbewertung eines thermohydraulischen Systems darstellen.

**Stand der Technik**

DE 32 01 799 C1, DE 19 704 609 C2 und DE 44 93 861 C1 beschreiben nadelförmige Sonden mit koaxialem Aufbau zur Messung der Leitfähigkeit, die auf der Messung eines zwischen der metallischen Sondenspitze und der äußeren Bezugselektrode fließenden Gleich- oder Wechselstroms beruhen. Diese technischen Lösungen dienen nur der Erfassung der Leitfähigkeit und sind daher nicht zur Differenzierung nichtleitfähiger Fluide geeignet.

Da Silva, M. J. u.a.: "A novel needle probe based on high-speed complex permittivity measurements for investigation of dynamic fluid flows" (IEEE Transactions on Instrumentation and Measurement 56(2007) Heft 4, S. 1249 bis 1256) beschreibt eine kapazitive messende Nadelsonde, die es erlaubt die elektrische Permittivität des umgebenden Mediums zu messen. Eine sichere Trennung aller drei Komponenten ist mit der kapazitiven Nadelsonde schwer, aber vor allem nicht zeitnah möglich, weil verfahrenstechnische interessante Komponenten hohe Dynamikunterschiede besitzen, beispielsweise schwankt der Dynamikbereich von Luft mit dem Wert 1 und Öl - ca. 2 zu Wasser - etwa 80.

In US 5995686 A, US 5005005 A und US 4851817 A werden optische Sonden beschrieben, die für eine Bestimmung von lokalem oder globalem Brechindex bzw. dessen zeitlicher Veränderung in einem Untersuchungsmedium ausgelegt sind. Dabei wird Licht von einem Sendeelement in ein lichtleitendes Element eingestrahlt und entweder die transmittierte Intensität am anderen Ende des lichtleitenden Elements gemessen, wobei das lichtleitende Element so manipuliert wurde, dass ein Teil des Lichtes in Abhängigkeit vom Brechindex aus dem lichtleitenden Element austreten kann, oder das andere Ende des lichtleitenden Elements wird offen als Sensor genutzt und es wird die in Abhängigkeit vom Brechindex des Mediums am offenen Ende reflektierte Intensität mittels eines Faser-Splitters und eines Detektors gemessen. Mit diesen Anordnungen können sehr gut Gase von Fluiden in leitfähigen und nichtleitfähigen Medien differenziert werden. Die Unterscheidung von verschiedenen Fluiden mit ähnlichem Brechindex ist aber nur bedingt nicht möglich.

DE 100 12 938 A1 beschreibt eine nadelförmige Sonde, bei der die zentrale Anregungselektrode als isoliertes Mantelthermoelement ausgeführt wird, wobei der elektrisch leitfähige Mantel des Thermoelements als Anregungselektrode für die Leitfähigkeitsmessung dient und die Temperatur als Differenzspannung zwischen den innerhalb des Mantelthermoelements gegen die Mantelelektrode isoliert eingebrachten Thermodrähten gemessen wird. Auf Grund der erhöhten thermischen Trägheit der Temperaturmesssonde infolge des Wärmewiderstandes des Isolationsmaterials zwischen Thermomoelementmantel und den Thermodrähten ist eine synchrone Leitfähigkeits- und Temperaturmessung nicht möglich.

DE 10 2005 046 662 B3 beschreibt eine nadelförmige Sonde zur Messung der elektrischen Impedanz und der Temperatur in Fluiden. Die nadelförmige Sonde bzw. Nadelsonde weist ein zentrales Thermoelement mit einem Thermokontaktpunkt auf, wobei in dem Thermokontaktpunkt an der Spitze der Sonde die beiden Drähte des durch die Thermodrähte gebildeten Mittelleiters in direktem thermischen oder elektrischen Kontakt zum Medium stehen. Die Nadelsonde weist zudem eine Elektrodenanordnung mit einer das Thermoelement umgebenden Schirmelektrode und einer die Schirmelektrode umgebenden Referenzelektrode auf, wobei das Thermoelement zudem als Anregungselektrode dient. Ferner ist eine Messschaltung mit einem Temperaturmesszweig und einem Impedanzmesszweig vorgesehen, wobei der Impedanzmesszweig eine Wechselspannungsquelle, einen Operationsverstärker und einen Amplituden-Phasen-Detektor aufweist. Das Thermoelement ist mit dem invertierenden Eingang des Operationsverstärkers verbunden, die Schirmelektrode und der nichtinvertierende Eingang des Operationsverstärkers sind mit der Wechselspannungsquelle verbunden. Der Ausgang des Operationsverstärkers ist mit dem Amplituden-Phasen-Detektor verbunden, wobei das Ausgangssignal des Operationsverstärkers mittels des Amplituden-Phasen-Detektors unter Charakterisierung der Impedanz des erfassten Fluids ausgewertet wird.

DE 102010 030 131 A1 beschreibt ein Handgerät zum Durchdringen einer Wärme-Isolationsschicht eines korrosionsanfälligen metallischen Gegenstandes und zum Untersuchen der Rohrleitung auf Korrosion. Der Nachweis von Rost erfolgt in der Anmeldung bevorzugt mit einem auf der Platte des Durchdringungskörpers aufgebrachten Trägermaterial (Gel Vlies), welches den chemischen Nachweis der Eisen-Ionen gewährleistet, der dann spektroskopisch ausgewertet wird.

Mena et al. beschreiben in "Measurement of gas-phase characteristics using a monofibre optical probe in a three-phase flow" (Chem. Eng. Sci., Bd. 63, Nr. 16, Seiten 4100 - 4115) die Verwendung einer faseroptischen Sonde zur Charakterisierung dreiphasiger Strömungen mit einer gasförmigen, einer flüssigen und einer festen Phase.

**Darstellung der Erfindung**

Industriell zu untersuchende Stoffgemische bestehen gewöhnlich nicht nur aus zwei Komponenten.

Technische Aufgabe

Aufgabe der vorliegenden Erfindung ist es, eine Anordnung zur Verfügung zu stellen, die eine sichere Unterscheidung von mehrphasigen Stoffgemischen, wovon eine Phase gasförmig und zwei Phasen flüssig sind, ermöglicht, wobei vorrangig gasförmige und flüssige Phasen bestimmt werden sollen.

Technische Lösung

Die Aufgabe wird gelöst durch den Gegenstand gemäß den Ansprüchen 1 und 2, Ausführungsformen derselben ergeben sich aus den abhängigen Ansprüchen. Die Erfindung betrifft demgemäß insbesondere eine Nadelsonde, die sowohl die Bestimmung der gasförmigen Phase als auch der flüssigen Phasen ermöglicht.

Die Nadelsonde umfasst einen metallisierten Mantel 6 der sich im Untersuchungsmedium befindet, einen im Inneren des metallisierten Mantels angeordneten Lichtwellenleiter 1, eine um den Lichtwellenleiter 1 bzw. den metallisierten Mantel 6 und gegen diesen mittels eines Isolators 4 elektrisch isoliert angeordnete hohlzylinderförmige Schirmelektrode **2,** eine um die Schirmelektrode **2** und gegen diese mittels eines Isolators elektrisch isoliert angeordnete hohlzylinderförmige Bezugselektrode 3, und eine an die Nadelsonde angeschlossene Messschaltung, wobei die Messschaltung sowohl die optischen Brechindexeigenschaften im Medium als auch die Leitfähigkeit des Mediums auswertet.

Vorteilhafte Wirkungen

Die flüssigen Phasen lassen sich dann über ihre Leitfähigkeit oder Permittivität sicher unterscheiden, und die Differenzierung der Gasphase erfolgt über den Brechindex. Der Sensor wird damit sehr robust gegen Störeinflüsse, weil beide Signalanteile (Brechindex und elektrische Impedanz bzw. Permittivität) binarisiert werden können, was eine aufwändige Kalibrierung und Temperaturkompensation unnötig macht.

Das Vorhandensein von festen Schwebstoffen in dem mehrphasigen Stoffgemisch behindert bei geringen Konzentrationen der festen Schwebstoffe nicht die korrekte Detektion der gas- und flüssigen Phasen.

**Kurze Beschreibung der Zeichnungen**

Fig. 1 zeigt die erfindungsgemäße Nadelsonde zur schnellen und gleichzeitigen Messung der lokalen elektrischen Impedanz und des Brechindexes in Fluiden mit der für die Messung erforderlichen Messeinrichtung.

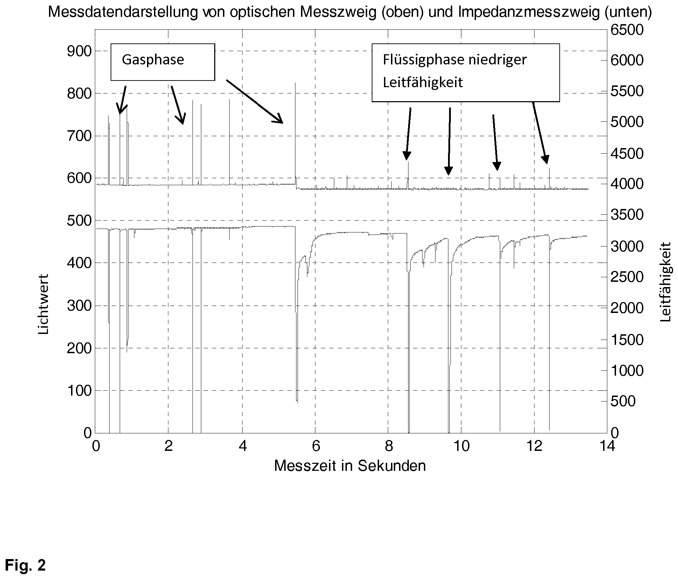

Fig. 2 zeigt die Messergebnisse eines Prototyps.

Fig. 3 zeigt ein Schema für die Auswertung der gemessenen Messwerte.

Fig. 4 verdeutlicht durch die parallele Auswertung die Identifikation der jeweiligen Phasen.

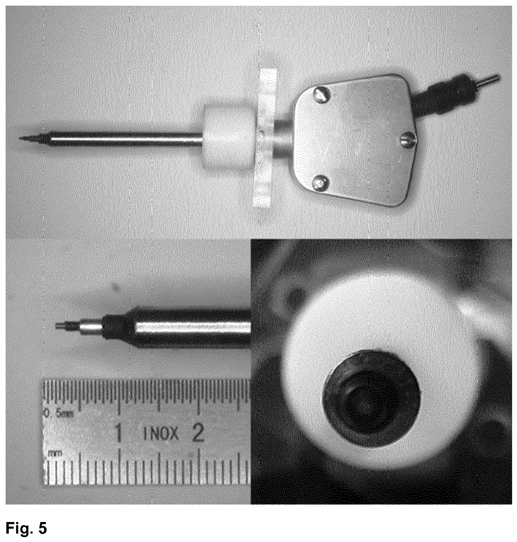

Die Fotos in Fig. 5 zeigen den aufgebauten Prototypen in drei Ansichten: Bildteil a) Gesamtansicht der Sonde, Bildteil b) Detailansicht der Sondenspitze als Seitenansicht, Bildteil c) Draufsicht auf die Sondenspitze.

**Bester Weg zur Ausführung der Erfindung**

Die Sonde besitzt eine für den Messzweck vorteilhafte koaxiale Struktur. Als zentrale Messspitze dient eine metallisierte Lichtleitfaser, deren metallischer Mantel als Elektrode für die Impedanzmessung dient. Dieser wird von einer isolierenden Hülle umgeben. Darum ist eine Schirmelektrode angeordnet, die wiederum von einer isolierenden Hülle umgeben ist. Den radialen Abschluss bildet die äußere Bezugselektrode. Die Spitze der Sonde befindet sich in direktem Kontakt mit dem umgebenden Medium. Die erfindungsgemäße zugehörige Messeinrichtung beinhaltet eine Auswertung des Brechindexes des Medium und der Impedanzmessung des Mediums.

**Wege zur Ausführung der Erfindung**

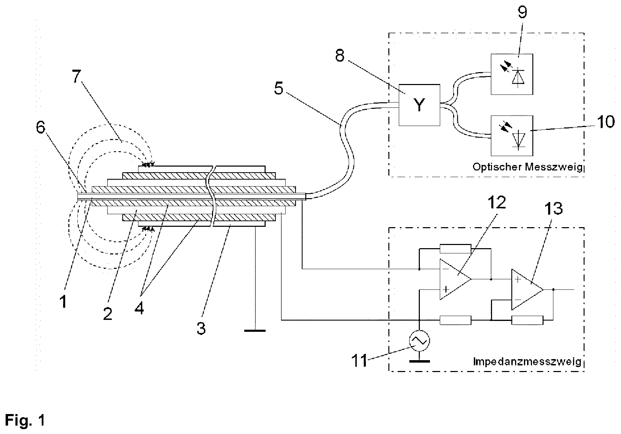

Die erfindungsgemäße Anordnung, siehe Fig. 1, besteht aus einer triaxial aufgebauten Nadelsonde, mit einem im Inneren der Sonde angeordneten Lichtleiter **1** mit metallisiertem Mantel **6** welcher sich im Untersuchungsmedium befindet, einer um den Lichtleiter **1** und gegen dessen metallisierten Mantel **6** mittels eines Isolators **4** elektrisch isoliert angeordneten hohlzylinderförmigen Schirmelektrode **2** und einer um die Schirmelektrode **2** und gegen diese mittels eines zweiten Isolators **4** elektrisch isoliert angeordneten hohlzylinderförmigen Bezugselektrode 3, sowie einer an diese Sonde angeschlossenen Messschaltung, bestehend aus einem optischen Messzweig sowie einem Impedanz-Messzweig.

Der Impedanz-Messzweig umfasst eine Wechselspannungsquelle **11,** einen Transimpedanzverstärker **12** und einen Differenzverstärker **13.**

Idealerweise umfasst der optische Messzweig ein optisches Sendeelement **9** und einen optischen Empfänger **10,** wobei durch einen optionalen optischen Koppler die Sende- und Empfangslichtsignale getrennt werden können.

Bei der erfindungsgemäßen Anordnung ist der metallisierte Mantel **6** des Lichtleiters **1** der Sonde mit dem invertierenden Eingang eines hochohmigen Transimpedanzverstärkers **12** elektrisch verbunden, die Schirmelektrode **2** ist mit dem nichtinvertierenden Eingang des Transimpedanzverstärkers **12** elektrisch verbunden und die Bezugselektrode 3 ist mit dem Massepotential der Schaltung elektrisch verbunden. Die Schirmelektrode **2** wird mit einer Rechteck-, Trapez oder Sinus-förmigen Wechselspannung aus einer niederohmigen Wechselspannungsquelle **11** beaufschlagt. Aufgrund der Beschaltung des Transimpedanzverstärkers mit einer Rückkoppelimpedanz $Z_f$ zwischen invertierendem Eingang und Ausgang entsteht ein virtueller Kurzschluss der Operationsverstärkereingänge, der dafür sorgt, dass die anregende Wechselspannung annähernd phasengleich auf der Schirmelektrode **2** und dem metallisierten Mantel **6** des Lichtleiters **1** anliegt. Zwischen dem metallisierten Mantel **6** und der Bezugselektrode 3 wird ein elektrisches Feld ausgeprägt, wobei sich die Feldlinien **7** wie gewünscht an der Sondenspitze um die Spitze des Lichtleiters **1** konzentrieren, wohingegen die Schirmelektrode **2** für eine Verdrängung der Feldlinien **7** aus dem Sondeninneren bzw. von der Sondengrenzfläche an der Sondenspitze sorgt. Über die elektrische Impedanz des umgebenden Mediums an der Sondenspitze stellt sich ein entsprechender Stromfluss ein, der vom Transimpedanzverstärker **12** in eine äquivalente Ausgangsspannung gewandelt wird. Mittels eines Differenzverstärkers **13** wird das Anregungssignal wieder vom Messsignal abgezogen, so dass das Differenzsignal ein lineares Maß für den Stromfluss an der Sondenspitze und damit die Impedanz des Mediums darstellt.

Gleichzeitig wird in den Lichtleiter **1** über ein optisches Kabel **5** sowie einen optischen Koppler **8** durch ein optisches Sendeelement **9** ein Lichtsignal eingeprägt. An der Spitze der Nadelsonde tritt dieses Lichtsignal aus dem Lichtleiter aus. Ein Teil des Lichtes wird jedoch an der Grenzfläche zwischen dem Lichtleiter **1** und dem umgebenden Medium in den Lichtleiter **1** zurückreflektiert. Der reflektierte Anteil ist abhängig vom Brechindex des umgebenden Mediums. Bei großem Brechindex (Flüssigkeit) tritt ein Großteil des Lichts aus dem Lichtleiter **1** aus. Bei geringem Brechindex (Gas) des umgebenden Mediums wird durch die Totalreflexion an der Grenzfläche ein größerer Anteil des Lichtes in den Lichtleiter **1** zurückreflektiert, durch das optische Kabel **5** und den optischen Koppler **8** zum optischen Empfänger **10** transportiert und dort in ein verwertbares elektrisches Signal gewandelt. Die Ausgangsspannung des optischen Empfängers **10** ist damit ein Maß für den Brechindex des umgebenden Mediums.

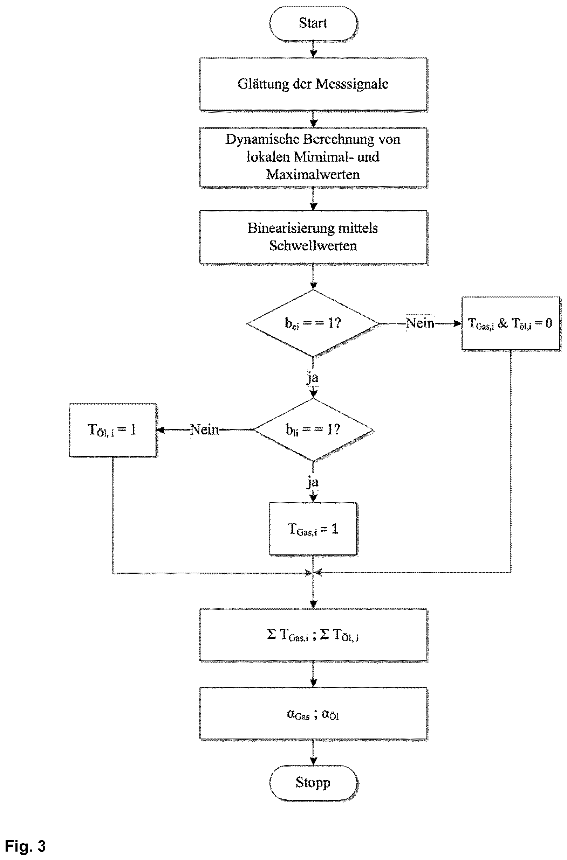

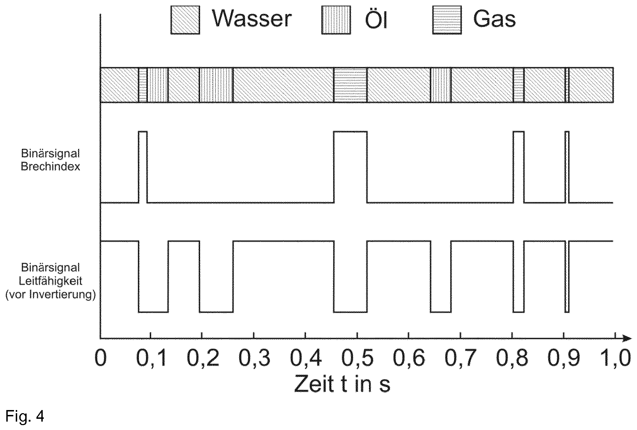

Zur Phasenunterscheidung werden die Ausgangssignale beider Messzweige zeitkontinuierlich binarisiert, wobei die Ausgansspannung des optischen Empfängers bei Gasphase als steigendes Signal ausgeprägt ist und das Differenzzignal des Impedanzmesszweiges bei veränderter Flüssigphase als fallendes Signal angesehen wird, vgl. Fig. 3 und Fig. 4. Die Binarisierung erfolgt mittels zweier Schwellwerte ($s_{x+}$, $s_{x-}$) die durch geeignete Schwellwertfaktoren aus den jeweiligen Signalhüben, welche durch die Differenz der Maximal- und Minimalwerte der entsprechenden Ausgangssignale der Messzweige bestimmt sind, gebildet werden. Die Binarisierung des Ausgangssignals des optischen Messzweiges erfolgt so, dass ein high-aktives Binärsignal der binarisierten Ausgangsspannung die Gasphase zum Messzeitpunkt repräsentiert. Der Zustandswechsel vom low- zum high-aktiven Bereich des Binärsignals des optischen Messzweigs erfolgt beim steigenden Ausgangssignal durch einen Phasenwechsel von Flüssig- zu Gasphase in der steigenden Flanke der Ausgangsspannung.

$$b_{optisch,xi} = \begin{cases} x_i < s_{x-} = 1 \\ x_i > s_{x+} = 0 \end{cases} \qquad b_{xi} \in \{0,1\}$$

Die Binarisierung des Ausgangssignals des Impedanzmesszweiges erfolgt so, dass ein high-aktives Binärsignal der Aussgangsspannung den Impedanzwechsel repräsentiert. Der Zustandswechsel vom low- zum high-aktiven Bereich des Binärsignals des Impedanzmesszweiges erfolgt beim fallenden Ausgangssignal bei Phasenwechsel in der fallenden Flanke der Differenzspannung.

$$b_{elektrisch,xi} = \begin{cases} x_i > s_{x+} = 1 \\ x_i < s_{x-} = 0 \end{cases} \qquad b_{xi} \in \{0,1\}$$

Die Phasenunterscheidung erfolgt über den zeitkontinuierlichen Vergleich des Signalzustandes der Binärsignale des optischen Messzweiges und des Impedanzmesszweiges. Ein zeitkontinuierlicher high-aktiver Bereich beider Binärsignale definiert einen diskreten Zeitbereich der Gasphase. Also ist eine Zeitspanne *(TGasphase)* der Gasphase als logische UND-Verknüpfung der Binärsignale des optischen Messzweiges und des Impedanzmesszweiges beschrieben.

$$T_{Gasphase} = \sum_i \left[ \left( b_{optisch} \cup b_{elektrisch} \right) = 1 \right]$$

Ein Flüssigkeitswechsel erfolgt durch einen Zustandswechsel im Binärsignal des Impedanzmesszweiges bei gleichzeitig low-aktiven Signalzustands des Binärsignals des optischen Messzweiges. Eine Zeitspanne einer nicht leitfähigen Flüssigphase (*TFI, nichtleitfähig*) ist nun als logische- Subtraktion der der Binärsignale des optischen Messzweiges und des Impedanzmesszweiges beschrieben.

$$T_{FI,nichtleitfähig} = \sum_i \left[ \left( b_{optisch} - b_{elektrisch} \right) = 1 \right]$$

Die Zeitspanne des Gesamtmesszeitraumes, die nicht als Zeitspanne der Gasphase bzw. der nicht leitfähigen Flüssigphase definiert ist, wird nun der dritten Phase (leitfähige Flüssigkeit) des Strömungsgemisches zugeordnet.

Zur Bestimmung der lokalen Phasengehalte werden die entsprechend bestimmten Zeitspannen der Phasen auf die Gesamtzeitspanne des Messzeitraumes bezogen. Dabei ist der lokale Phasengehalt einer Phase der Quotient aus der Zeitspanne der Phase und der Gesamtzeitspanne des Messzeitraumes.

$$\alpha(xi) = \lim_{T \to \infty} \left( \frac{\sum_i T_{xi}}{T} \right)$$

Beispielsweise wurde ein Prototyp auf Basis einer kupferummantelten Faser aufgebaut, der in Fig. 5 gezeigt ist. Die leitfähige Kupferbeschichtung wurde dabei direkt als Messelektrode verwendet. Dies ermöglichte eine, im Vergleich zu anderen Sonden, kleine Sondenspitze. Daraus folgt wiederum, dass die Durchmesser der Schirm- und der Bezugselektrode ebenfalls in kleineren Dimensionen ausgeführt werden konnten. Auf Grund dieser kleineren Abmessungen hat sich gezeigt, dass sich die Bestandteile der Mehrphasenströmung gut durch die Sondenspitze bewegen. Die Kombination aus Faser und Kupferbeschichtung ist ebenfalls gut zu bearbeiten. Somit wurde eine gute optische Signalqualität erwartet. Durch den festen Verbund der Kupferschicht mit dem Quarzglas kann von einer kraft- und formschlüssigen Sondenspitze (eindeutige Sondenspitze) ausgegangen werden.

Als Ausgangsbasis wurden auch Polymerfasern verwendet.

Die Verwendung von Edelstahlröhrchen für die inneren und äußeren Elektroden ist möglich. Die Sonden wurden in verschiedenen Einbaulagen, direkt von oben, direkt von der Seite oder in einem Einfallswinkel, getestet, wobei der Phasendurchgang an der Sondenspitze für die Überprüfung mit einer Kamera aufgenommen wurde.

## Gewerbliche Anwendbarkeit

Potentielle Einsatzgebiete des Sensors sind beispielsweise die Messung der Zusammensetzung von Stoffgemischen und deren Dispersionsgrad (z. B. eines Öl-Wasser-Gas-Gemisches in der Erdölförderung oder von flüssigen Reagenzien in physikalischen und chemischen Herstellungsprozessen) oder die Detektion von Verunreinigungen in einphasigen Medien.

In umfangreichen Untersuchungen wurde die Funktionstüchtigkeit an verschiedenen Prototypen nachgewiesen.

Fig. 4 verdeutlicht die Erkennung der einzelnen Phasen in einer Mehrphasenströmung. Im oberen Bildbereich ist der jeweilig Zustand anhand eines In Abhängigkeit der ausgewerteten Signale des optischen und des Impedanz-Messkreises kann die entsprechende Phase erkannt werden.

**Bezugzeichenliste**

1   Lichtleiter
2   Schirmelektrode
3   Bezugselektrode
4   Elektrische Isolation
5   Optisches Kabel (LWL)
6   Metallisierter Mantel
7   Feldlinien des elektrischen Feldes
8   Optischer Koppler
9   Optisches Sendeelement
10   Optischer Empfänger
11   Wechselspannungsquelle
12   Transimpedanzverstärker
13   Differenzverstärker

**Patentansprüche**

1.   Nadelsonden-Anordnung zur Bestimmung der Phasenanteile eines Untersuchungsmediums mit einer Gasphase, einer elektrisch nicht leitfähigen ersten Flüssigphase und einer elektrisch leitfähigen zweiten Flüssigphase, aufweisend eine Nadelsonde und eine an die Nadelsonde angeschlossene Messeinrichtung, wobei die Nadelsonde einen im Inneren der Nadelsonde angeordneten Lichtleiter (1) mit einem metallisierten Mantel (6) zum Einbringen in das Untersuchungsmedium, eine um den Lichtleiter (1) mit seinem metallisierten Mantel (6) und gegen diese mittels eines Isolators (4) elektrisch isoliert angeordnete hohlzylinderförmige Schirmelektrode (2), und eine um die Schirmelektrode (2) und gegen diese mittels eines Isolators (4) elektrisch isoliert angeordnete hohlzylinderförmige Bezugselektrode (3) aufweist, und wobei die Messeinrichtung eine Messschaltung mit einem optischen Messzweig und einem Impedanzmesszweig aufweist, wobei

a. der Lichtleiter (1) mit einem optischen Sendeelement (9) und einem optischen Empfänger (10) in dem optischen Messzweig verbunden ist, wobei die Messeinrichtung basierend auf der von dem Empfänger (10) erfassten Lichtmenge zum Erfassen des Brechungsindex der vorliegenden Phase des Untersuchungsmediums als Brechungsindex-Signal ausgebildet ist,

b. der Impedanz-Messzweig eine Wechselspannungsquelle (11), einen Transimpedanzverstärker (12) und einen Differenzverstärker (13) umfasst,

c. der metallisierte Mantel (6) des Lichtleiters (1) elektrisch mit dem invertierenden Eingang des Transimpedanzverstärkers (12) verbunden ist, die Schirmelektrode (2) und der nichtinvertierende Eingang des Transimpedanzverstärkers (12) elektrisch mit der Wechselspannungsquelle (11) verbunden sind, die zum Aufprägen einer Wechselspannung auf die Schirmelektrode (2) vorgesehen ist,

d. die Messeinrichtung derart ausgebildet ist, dass die Anregungsspannung der Wechselspannungsquelle (11) vom Ausgang des Transimpedanzverstärkers (12) mittels des Differenzverstärkers (13) wieder abgezogen wird, so dass am Ausgang des Impedanzmesszweiges eine zur elektrischen Leitfähigkeit des Mediums proportionale Ausgangsspannung vorliegt, wobei die Messeinrichtung basierend auf der Ausgangsspannung zum Erfassen der Leitfähigkeit der vorliegenden Phase des Untersuchungsmediums als Leitfähigkeits-Signal ausgebildet ist, wobei

e. die Messeinrichtung zur Binarisierung des Brechungsindex-Signals mittels eines unteren und eines oberen Brechungsindex-Schwellwertes ($s_{x-}$, $s_{x+}$) derart ausgebildet ist, dass ein Brechungsindex unterhalb des unteren Brechungsindex-Schwellwertes einem ersten Signalzustand und ein Brechungsindex oberhalb des oberen Brechungsindex-Schwellwertes einem zweiten Signalzustand des binarisierten Brechunsindex-Signals ($b_{optisch}$) entspricht, wobei

f. die Messeinrichtung zur Binarisierung des Leitfähigkeits-Signals mittels eines unteren und eines oberen Leitfähigkeits-Schwellwertes ($s_{x-}$, $s_{x+}$) derart ausgebildet ist, dass eine Leitfähigkeit unterhalb des unteren Leitfähigkeits-Schwellwertes einem ersten Signalzustand und eine Leitfähigkeit oberhalb des oberen Schwellwertes einem zweiten Signalzustand des binarisierten Leitfähigkeits-Signals ($b_{elektrisch}$) entspricht, und wobei

g. die Messeinrichtung derart konfiguriert ist, dass es von ihr als Vorliegen der Gasphase des Untersuchungsmediums gewertet wird, wenn das binarisierte Brechungsindex-Signal ($b_{optisch}$) seinen ersten Signalzustand und das binarisierte Leitfähigkeits-Signal seinen ersten Signalzustand aufweist, dass es von ihr als Vorliegen der elektrisch nicht leitfähigen ersten Flüssigphase gewertet wird, wenn das binarisierte Brechungsindex-Signal seinen zweiten Signalzustand und das binarisierte Leitfähigkeits-Signal seinen ersten Signalzustand aufweist, und dass von ihr alle übrigen Kombinationen der Signalzustände des binarisierten Brechungsindex-Signals und des binarisierten Leitfähigkeits-Signals als Vorliegen der elektrisch leitfähigen zweiten Flüssigphase gewertet werden.

2. Nadelsonden-Anordnung zur Bestimmung der Phasenanteile eines Untersuchungsmediums mit einer Gasphase, einer elektrisch nicht leitfähigen ersten Flüssigphase und einer elektrisch leitfähigen zweiten Flüssigphase, aufweisend

- eine Nadelsonde und
- eine an die Nadelsonde angeschlossene Messeinrichtung, wobei die Nadelsonde einen im Inneren der Nadelsonde angeordneten Lichtleiter (1) in einem Edelstahlkanülrohr zum Einbringen in das Untersuchungsmedium, eine um den Lichtleiter (1) in seinem Edelstahlkanülrohr und gegen diese mittels eines Isolators (4) elektrisch isoliert angeordnete hohlzylinderförmige Schirmelektrode (2), und eine um die Schirmelektrode (2) und gegen diese mittels eines Isolators (4) elektrisch isoliert angeordnete hohlzylinderförmige Bezugselektrode (3) aufweist, und wobei die Messeinrichtung eine Messschaltung mit einem optischen Messzweig und einem Impedanzmesszweig aufweist, wobei

a. der Lichtleiter (1) mit einem optischen Sendeelement (9) und einem optischen Empfänger (10) in dem optischen Messzweig verbunden ist, wobei die Messeinrichtung basierend auf der von dem Empfänger (10) erfassten Lichtmenge zum Erfassen des Brechungsindex der vorliegenden Phase des Untersuchungsmediums als Brechungsindex-Signal ausgebildet ist,

b. der Impedanz-Messzweig eine Wechselspannungsquelle 11), einen Transimpedanzverstärker (12) und einen Differenzverstärker (13) umfasst,

c. das Edelstahlkanülrohr elektrisch mit dem invertierenden Eingang des Transimpedanzverstärkers (12) verbunden ist, die Schirmelektrode (2) und der nichtinvertierende Eingang des Transimpedanzverstärkers (12) elektrisch mit der Wechselspannungsquelle (11) verbunden sind, die zum Aufprägen einer Wechselspannung auf die Schirmelektrode (2) vorgesehen ist,

d. die Messeinrichtung derart ausgebildet ist, dass die Anregungsspannung der Wechselspannungsquelle (11) vom Ausgang des Transimpedanzverstärkers (12) mittels des Differenzverstärkers (13) wieder abgezogen wird, so dass am Ausgang des Impedanzmesszweiges eine zur elektrischen Leitfähigkeit des Mediums proportionale Ausgangsspannung vorliegt, wobei die Messeinrichtung basierend auf der Ausgangsspannung zum Erfassen der Leitfähigkeit der vorliegenden Phase des Untersuchungsmediums als Leitfähigkeits-Signal ausgebildet ist, wobei

e. die Messeinrichtung zur Binarisierung des Brechungsindex-Signals mittels eines unteren und eines oberen Brechungsindex-Sehwellwertes (sx-, sx+) derart ausgebildet ist, dass ein Brechungsindex unterhalb des unteren BrechungsindexSehwellwertes einem ersten Signalzustand und ein Brechungsindex oberhalb des oberen Brechungsindex-Sehwellwertes einem zweiten Signalzustand des binarisierten Brechunsindex-Signals (b_optisch) entspricht, wobei

f. die Messeinrichtung zur Binarisierung des Leitfähigkeits-Signals mittels eines unteren und eines oberen Leitfähigkeits-Sehwellwertes (sx-, sx+) derart ausgebildet ist, dass eine Leitfähigkeit unterhalb des unteren Leitfähigkeits-Sehwellwertes einem ersten Signalzustand und eine Leitfähigkeit oberhalb des oberen Sehwellwertes einem zweiten Signalzustand des binarisierten Leitfähigkeits-Signals (b_elektrisch) entspricht, und wobei

g. die Messeinrichtung derart konfiguriert ist, dass es von ihr als Vorliegen der Gasphase des Untersuchungsmediums gewertet wird, wenn das binarisierte Brechungsindex-Signal seinen ersten Signalzustand und das binarisierte Leitfähigkeits-Signal seinen ersten Signalzustand aufweist, dass es von ihr als Vorliegen der elektrisch nicht leitfähigen ersten Flüssigphase gewertet wird, wenn das binarisierte Brechungsindex-Signal seinen zweiten Signalzustand und das binarisierte Leitfähigkeits-Signal seinen ersten Signalzustand aufweist, und dass von ihr alle übrigen Kombinationen der Signalzustände des binarisierten Brechungsindex-Signals und des binarisierten Leitfähigkeits-Signals als Vorliegen der elektrisch leitfähigen zweiten Flüssigphase gewertet werden.

3. Nadelsonden-Anordnung nach Anspruch 1 oder 2, **dadurch gekennzeichnet, dass** im optischen Messzweig ein optischer Koppler (8) enthalten ist.

4. Nadelsonden-Anordnung nach Anspruch 1 oder nach Anspruch 3 wenn abhängig von Anspruch 1, **dadurch gekennzeichnet, dass** der metallisierte Mantel (6) des Lichtleiters (1) druckfest mit einer Dichtscheibe zur Druckaufnahme und Abdichtung verbunden ist.

5. Nadelsonden-Anordnung nach Anspruch 4, **dadurch gekennzeichnet, dass** die Verbindung der Dichtscheibe mit dem metallisierten Mantel (6) des Lichtleiters (1) durch eine Lötverbindung oder Schweissverbindung gebildet ist.

6. Nadelsonden-Anordnung nach einem der vorhergehenden Ansprüche, **dadurch gekennzeichnet, dass** dem Ausgang des Transimpedanzverstärkers (12) ein I/Q-Demodulator nachgeschaltet ist, der zum Ausgeben des Real- und den Imaginärteils des Wechselspannungssignals als Messwerte ausgebildet ist.

7. Nadelsonden-Anordnung nach einem der vorhergehenden Ansprüche, **dadurch gekennzeichnet, dass** der Ausgang des Differenzverstärkers (13) mit einem Analog-Digital-Wandler verbunden ist.


**Claims**

1. Needle probe arrangement for determining the phase proportions of an examination medium having a gas phase, an electrically non-conductive first liquid phase and an electrically conductive second liquid phase, comprising a needle probe and a measuring device connected to the needle probe, wherein the needle probe comprises an optical waveguide (1) arranged in the interior of the needle probe and having a metallized cladding (6) for insertion into the examination medium, a hollow-cylindrical shielding electrode (2) arranged around the optical waveguide (1) with the metallized cladding (6) thereof and in a manner electrically insulated therefrom by means of an insulator (4), and a hollow-cylindrical reference electrode (3) arranged around the shielding electrode (2) and in a manner electrically insulated therefrom by means of an insulator (4), and wherein the measuring device comprises a measuring circuit having an optical measurement branch and an impedance measurement branch, wherein

    a. the optical waveguide (1) is connected to an optical transmission element (9) and an optical receiver (10) in the optical measurement branch, wherein the measuring device, on the basis of the quantity of light detected by the receiver (10), is configured for detecting the refractive index of the present phase of the examination medium as a refractive index signal,
    b. the impedance measurement branch comprises an AC voltage source (11), a transimpedance amplifier (12) and a differential amplifier (13),
    c. the metallized cladding (6) of the optical waveguide (1) is electrically connected to the inverting input of the transimpedance amplifier (12), the shielding electrode (2) and the non-inverting input of the transimpedance amplifier (12) are electrically connected to the AC voltage source (11), which is provided for impressing an AC voltage on the shielding electrode (2),
    d. the measuring device is configured in such a way that the excitation voltage of the AC voltage source (11) is subtracted again from the output of the transimpedance amplifier (12) by means of the differential amplifier (13), such that an output voltage proportional to the electrical conductivity of the medium is present at the output of the impedance measurement branch, wherein the measuring device, on the basis of the output voltage, is configured for detecting the conductivity of the present phase of the examination medium as a conductivity signal, wherein
    e. the measuring device is configured for binarizing the refractive index signal by means of a lower and an upper refractive index threshold value ($s_{x-}$, $s_{x+}$) in such a way that a refractive index below the lower refractive index threshold value corresponds to a first signal state and a refractive index above the upper refractive index threshold value corresponds to a second signal state of the binarized refractive index signal ($b_{optical}$), wherein
    f. the measuring device is configured for binarizing the conductivity signal by means of a lower and an upper conductivity threshold value ($s_{x-}$, $s_{x+}$) in such a way that a conductivity below the lower conductivity threshold value corresponds to a first signal state and a conductivity above the upper threshold value corresponds to a second signal state of the binarized conductivity signal ($b_{electrical}$), and wherein
    g. the measuring device is configured in such a way that it judges the gas phase of the examination medium to be present if the binarized refractive index signal ($b_{optical}$) has its first signal state and the binarized conductivity signal has its first signal state, that it judges the electrically non-conductive first liquid phase to be present if the binarized refractive index signal has its second signal state and the binarized conductivity signal has its first signal state, and that it judges all other combinations of the signal states of the binarized refractive index signal and of the binarized conductivity signal to mean that the electrically conductive second liquid phase is present.

2. Needle probe arrangement for determining the phase proportions of an examination medium having a gas phase, an electrically non-conductive first liquid phase and an electrically conductive second liquid phase, comprising

   - a needle probe and
   - a measuring device connected to the needle probe, wherein the needle probe comprises an optical waveguide (1) arranged in the interior of the needle probe in a high-grade steel cannula tube for insertion into the examination medium, a hollow-cylindrical shielding electrode (2) arranged around the optical waveguide (1) in the high-grade steel cannula tube thereof and in a manner electrically insulated therefrom by means of an insulator (4), and a hollow-cylindrical reference electrode (3) arranged around the shielding electrode (2) and in a manner electrically insulated therefrom by means of an insulator (4), and wherein the measuring device comprises a measuring circuit having an optical measurement branch and an impedance measurement branch, wherein

   a. the optical waveguide (1) is connected to an optical transmission element (9) and an optical receiver (10) in the optical measurement branch, wherein the measuring device, on the basis of the quantity of light detected by the receiver (10), is configured for detecting the refractive index of the present phase of the examination medium as a refractive index signal,
   b. the impedance measurement branch comprises an AC voltage source (11), a transimpedance amplifier (12) and a differential amplifier (13),
   c. the high-grade steel cannula tube is electrically connected to the inverting input of the transimpedance amplifier (12), the shielding electrode (2) and the non-inverting input of the transimpedance amplifier (12) are electrically connected to the AC voltage source (11), which is provided for impressing an AC voltage on the shielding electrode (2),
   d. the measuring device is configured in such a way that the excitation voltage of the AC voltage source (11) is subtracted again from the output of the transimpedance amplifier (12) by means of the differential amplifier (13), such that an output voltage proportional to the electrical conductivity of the medium is present at the output of the impedance measurement branch, wherein the measuring device, on the basis of the output voltage, is configured for detecting the conductivity of the present phase of the examination medium as a conductivity signal, wherein
   e. the measuring device is configured for binarizing the refractive index signal by means of a lower and an upper refractive index threshold value ($s_{x-}$, $s_{x+}$) in such a way that a refractive index below the lower refractive index threshold value corresponds to a first signal state and a refractive index above the upper refractive index threshold value corresponds to a second signal state of the binarized refractive index signal ($b_{optical}$), wherein
   f. the measuring device is configured for binarizing the conductivity signal by means of a lower and an upper conductivity threshold value ($s_{x-}$, $s_{x+}$) in such a way that a conductivity below the lower conductivity threshold value corresponds to a first signal state and a conductivity above the upper threshold value corresponds to a second signal state of the binarized conductivity signal ($b_{electrical}$), and wherein
   g. the measuring device is configured in such a way that it judges the gas phase of the examination medium to be present if the binarized refractive index signal has its first signal state and the binarized conductivity signal has its first signal state, that it judges the electrically non-conductive first liquid phase to be present if the binarized refractive index signal has its second signal state and the binarized conductivity signal has its first signal state, and that it judges all other combinations of the signal states of the binarized refractive index signal and of the binarized conductivity signal to mean that the electrically conductive second liquid phase is present.

3. Needle probe arrangement according to Claim 1 or 2, **characterized in that** the optical measurement branch contains an optical coupler (8).

4. Needle probe arrangement according to Claim 1 or according to Claim 3 if dependent on Claim 1, **characterized in that** the metallized cladding (6) of the optical waveguide (1) is connected, in a pressure-resistant manner, to a sealing plate for absorbing pressure and sealing.

5. Needle probe arrangement according to Claim 4, **characterized in that** the connection of the sealing plate to the metallized cladding (6) of the optical waveguide (1) is formed by a soldering connection or welding connection.

**6.** Needle probe arrangement according to any of the preceding claims, **characterized in that** an I/Q demodulator is connected downstream of the output of the transimpedance amplifier (12) and is configured for outputting the real and imaginary parts of the AC voltage signal as measurement values.

**7.** Needle probe arrangement according to any of the preceding claims, **characterized in that** the output of the differential amplifier (13) is connected to an analog-to-digital converter.

**Revendications**

**1.** Agencement de sonde à aiguille pour déterminer l'équilibre des phases d'un milieu examiné ayant une phase gazeuse, une première phase liquide non électroconductrice et une deuxième phase liquide électroconductrice, présentant une sonde à aiguille et un dispositif de mesure connecté à la sonde à aiguille, dans lequel la sonde à aiguille présente un guide de lumière (1) disposé à l'intérieur de la sonde à aiguille et doté d'une gaine métallisée (6) à introduire dans le milieu examiné, une électrode de protection (2) cylindrique creuse disposée autour du guide de lumière (1) doté de sa gaine métallisée (6) et électriquement isolée par rapport à celle-ci au moyen d'un isolateur (4), et une électrode de référence (3) cylindrique creuse disposée autour de l'électrode de protection (2) et électriquement isolée par rapport à celle-ci au moyen d'un isolateur (4), et le dispositif de mesure présentant un circuit de mesure doté d'une branche de mesure optique et d'une branche de mesure d'impédance, dans lequel

a. le guide de lumière (1) est relié à un élément d'émission optique (9) et à un récepteur optique (10) dans la branche de mesure optique, le dispositif de mesure étant réalisé pour détecter l'indice de réfraction de la phase présente du milieu examiné sous forme de signal d'indice de réfraction sur la base de la quantité de lumière détectée par le récepteur (10),

b. la branche de mesure d'impédance comprend une source de tension alternative (11), un amplificateur à transimpédance (12) et un amplificateur différentiel (13),

c. la gaine métallisée (6) du guide de lumière (1) est reliée électriquement à l'entrée inverseuse de l'amplificateur à transimpédance (12), l'électrode de protection (2) et l'entrée non inverseuse de l'amplificateur à transimpédance (12) sont électriquement reliées à la source de tension alternative (11) qui est prévue pour appliquer une tension alternative à l'électrode de protection (2),

d. le dispositif de mesure est réalisé de telle sorte que la tension d'excitation de la source de tension alternative (11) est à nouveau soustraite de la sortie de l'amplificateur à transimpédance (12) au moyen de l'amplificateur différentiel (13) de sorte qu'à la sortie de la branche de mesure d'impédance, une tension de sortie proportionnelle à la conductivité électrique du milieu est présente, le dispositif de mesure étant réalisé pour détecter la conductivité de la phase présente du milieu examiné sous forme de signal de conductivité sur la base de la tension de sortie, dans lequel

e. le dispositif de mesure est réalisé pour la binarisation du signal d'indice de réfraction au moyen d'une valeur seuil d'indice de réfraction inférieure et supérieure ($s_{x-}$, $s_{x+}$) de telle sorte qu'un indice de réfraction au-dessous de la valeur seuil d'indice de réfraction inférieure correspond à un premier état de signal et qu'un indice de réfraction au-dessus de la valeur seuil d'indice de réfraction supérieure correspond à un deuxième état de signal du signal d'indice de réfraction binarisé ($b_{optisch}$), dans lequel

f. le dispositif de mesure est réalisé pour la binarisation du signal de conductivité au moyen d'une valeur seuil de conductivité inférieure et supérieure ($s_{x-}$, $s_{x+}$) de telle sorte qu'une conductivité au-dessous de la valeur seuil de conductivité inférieure correspond à un premier état de signal et qu'une conductivité au-dessus de la valeur seuil supérieure correspond à un deuxième état de signal du signal de conductivité binarisé ($b_{elektrisch}$), et dans lequel

g. le dispositif de mesure est configuré de telle sorte qu'il juge que la phase gazeuse du milieu examiné est présente si le signal d'indice de réfraction binarisé ($b_{optisch}$) présente son premier état de signal et le signal de conductivité binarisé présente son premier état de signal, qu'il juge que la première phase liquide non électroconductrice est présente si le signal d'indice de réfraction binarisé présente son deuxième état de signal et le signal de conductivité binarisé présente son premier état de signal, et qu'il juge que la deuxième phase liquide électroconductrice est présente dans toutes les autres combinaisons des états de signal du signal d'indice de réfraction binarisé et du signal de conductivité binarisé.

**2.** Agencement de sonde à aiguille pour déterminer l'équilibre des phases d'un milieu examiné ayant une phase gazeuse, une première phase liquide non électroconductrice et une deuxième phase liquide électroconductrice, présentant

- une sonde à aiguille, et
- un dispositif de mesure relié à la sonde à aiguille, dans lequel la sonde à aiguille présente un guide de lumière (1) disposé à l'intérieur de la sonde à aiguille dans un tuyau de canule en inox à introduire dans le milieu examiné, une électrode de protection (2) cylindrique creuse disposée autour du guide de lumière (1) dans son tuyau de canule en inox et électriquement isolée contre celui-ci au moyen d'un isolateur (4), et une électrode de référence (3) cylindrique creuse disposée autour de l'électrode de protection (2) et électriquement isolée contre celle-ci au moyen d'un isolateur (4), et le dispositif de mesure présentant un circuit de mesure doté d'une branche de mesure optique et d'une branche de mesure d'impédance, dans lequel

a. le guide de lumière (1) est relié à un élément d'émission optique (9) et à un récepteur optique (10) dans la branche de mesure optique, le dispositif de mesure étant réalisé pour détecter l'indice de réfraction de la phase présente du milieu examiné sous forme de signal d'indice de réfraction sur la base de la quantité de lumière détectée par le récepteur (10),

b. la branche de mesure d'impédance comprend une source de tension alternative (11), un amplificateur à transimpédance (12) et un amplificateur différentiel (13),

c. le tuyau de canule en inox est relié électriquement à l'entrée inverseuse de l'amplificateur à transimpédance (12), l'électrode de protection (2) et l'entrée non inverseuse de l'amplificateur à transimpédance (12) sont électriquement reliées à la source de tension alternative (11) qui est prévue pour appliquer une tension alternative à l'électrode de protection (2),

d. le dispositif de mesure est réalisé de telle sorte que la tension d'excitation de la source de tension alternative (11) est à nouveau soustraite de la sortie de l'amplificateur à transimpédance (12) au moyen de l'amplificateur différentiel (13) de sorte qu'à la sortie de la branche de mesure d'impédance, une tension de sortie proportionnelle à la conductivité électrique du milieu est présente, le dispositif de mesure étant réalisé pour détecter la conductivité de la phase présente du milieu examiné sous forme de signal de conductivité sur la base de la tension de sortie, dans lequel

e. le dispositif de mesure est réalisé pour la binarisation du signal d'indice de réfraction au moyen d'une valeur seuil d'indice de réfraction inférieure et supérieure ($s_{x-}$, $s_{x+}$) de telle sorte qu'un indice de réfraction au-dessous de la valeur seuil d'indice de réfraction inférieure correspond à un premier état de signal et qu'un indice de réfraction au-dessus de la valeur seuil d'indice de réfraction supérieure correspond à un deuxième état de signal du signal d'indice de réfraction binarisé ($b_{optisch}$), dans lequel

f. le dispositif de mesure est réalisé pour la binarisation du signal de conductivité au moyen d'une valeur seuil de conductivité inférieure et supérieure ($s_{x-}$, $s_{x+}$) de telle sorte qu'une conductivité au-dessous de la valeur seuil de conductivité inférieure correspond à un premier état de signal et qu'une conductivité au-dessus de la valeur seuil supérieure correspond à un deuxième état de signal du signal de conductivité binarisé ($b_{elektrisch}$), et dans lequel

g. le dispositif de mesure est configuré de telle sorte qu'il juge que la phase gazeuse du milieu examiné est présente si le signal d'indice de réfraction binarisé présente son premier état de signal et le signal de conductivité binarisé présente son premier état de signal, qu'il juge que la première phase liquide non électroconductrice est présente si le signal d'indice de réfraction binarisé présente son deuxième état de signal et le signal de conductivité binarisé présente son premier état de signal, et qu'il juge que la deuxième phase liquide électroconductrice est présente dans toutes les autres combinaisons des états de signal du signal d'indice de réfraction binarisé et du signal de conductivité binarisé.

3. Agencement de sonde à aiguille selon la revendication 1 ou 2, **caractérisé en ce que** la branche de mesure optique comprend un coupleur optique (8).

4. Agencement de sonde à aiguille selon la revendication 1, ou selon la revendication 3 lorsqu'elle dépend de la revendication 1, **caractérisé en ce que** la gaine métallisée (6) du guide de lumière (1) est reliée de manière résistante à la pression à un disque d'étanchéité pour absorber la pression et assurer l'étanchéité.

5. Agencement de sonde à aiguille selon la revendication 4, **caractérisé en ce que** la liaison entre le disque d'étanchéité et la gaine métallisée (6) du guide de lumière (1) est formée par une liaison brasée ou une liaison soudée.

6. Agencement de sonde à aiguille selon l'une quelconque des revendications précédentes, **caractérisé en ce qu'**en aval de la sortie de l'amplificateur à transimpédance (12), un démodulateur I/Q est placé qui est réalisé pour sortir sous forme de valeurs mesurées la composante réelle et la composante imaginaire du signal de tension alternative.

7. Agencement de sonde à aiguille selon l'une quelconque des revendications précédentes, **caractérisé en ce que** la sortie de l'amplificateur différentiel (13) est reliée à un convertisseur analogique/numérique.

**Fig. 1**

Messdatendarstellung von optischen Messzweig (oben) und Impedanzmesszweig (unten)

Fig. 2

Fig. 3

Fig. 4

**Fig. 5**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 3201799 C1
- DE 19704609 C2
- DE 4493861 C1
- US 5995686 A
- US 5005005 A
- US 4851817 A
- DE 10012938 A1
- DE 102005046662 B3
- DE 102010030131 A1

### In der Beschreibung aufgeführte Nicht-Patentliteratur

- **DA SILVA, M. J.** A novel needle probe based on high-speed complex permittivity measurements for investigation of dynamic fluid flows. *IEEE Transactions on Instrumentation and Measurement,* 2007, vol. 56, 1249-1256
- **MENA et al.** Measurement of gas-phase characteristics using a monofibre optical probe in a three-phase flow. *Chem. Eng. Sci.,* vol. 63 (16), 4100-4115